# EUROPEAN PATENT APPLICATION

(11) **EP 2 354 268 A1**
(43) Date of publication of application: **10.08.2011**
(21) Application number: 09816064.1
(22) Date of filing: 14.09.2009
(51) Int. Cl.: C23C 14/02, C23C 14/06, C23C 14/34, G02B 5/20

(54) **METHOD OF MANUFACTURING OPTICAL FILTER**

(30) Priority: 25.09.2008 JP 2008246355
(71) Applicant: Shincron Co., Ltd., Kanagawa 220-8680 (JP)
(72) Inventor: SHIONO, Ichiro, Yokohama-shi Kanagawa 220-8680 (JP); SATO, Toshihiko, Yokohama-shi Kanagawa 220-8680 (JP); TOGASHI, Yasuhisa, Yokohama-shi Kanagawa 220-8680 (JP); JIANG, Yousong, Yokohama-shi Kanagawa 220-8680 (JP); SUGAWARA, Takuya, Yokohama-shi Kanagawa 220-8680 (JP)
(74) Representative: Grünecker, Kinkeldey, Stockmair & Schwanhäusser Anwaltssozietät
(86) International application number: PCT/JP2009/066015
(87) International publication number: WO 2010/035649

(57) **Abstract**

[Object] To provide a manufacturing method of an optical filter having favorable film quality by removing a foreign substance adhered onto a surface of a substrate by cleaning before a thin film is formed.

[Solution] By performing a cleaning step P1 for cleaning a substrate S by means of a solution including water, a pre-treatment step P3 for plasma-treating a surface of the substrate S cleaned in the cleaning step P1 by plasma of an oxygen gas, and a thin film formation step (P4, P5) for forming the thin film on the surface of the substrate S plasma-treated in the pre-treatment step P3, the foreign substance adhered onto the surface of the substrate can be effectively removed. In the pre-treatment step P3, only the oxygen gas is introduced to an area where the plasma is generated, and a flow rate of the oxygen gas to be introduced is greater than a flow rate of the oxygen gas introduced in the thin film formation step. Thus, the foreign substance adhered onto the surface of the substrate S through OH bonds in the cleaning step is effectively eliminated before the thin film formation step (P4, P5), so that generation of a film absent part is prevented.

## Description

### Technical Field

The present invention relates to a manufacturing method of an optical filter, particularly to a manufacturing method of an optical filter having favorable film quality.

### Background Art

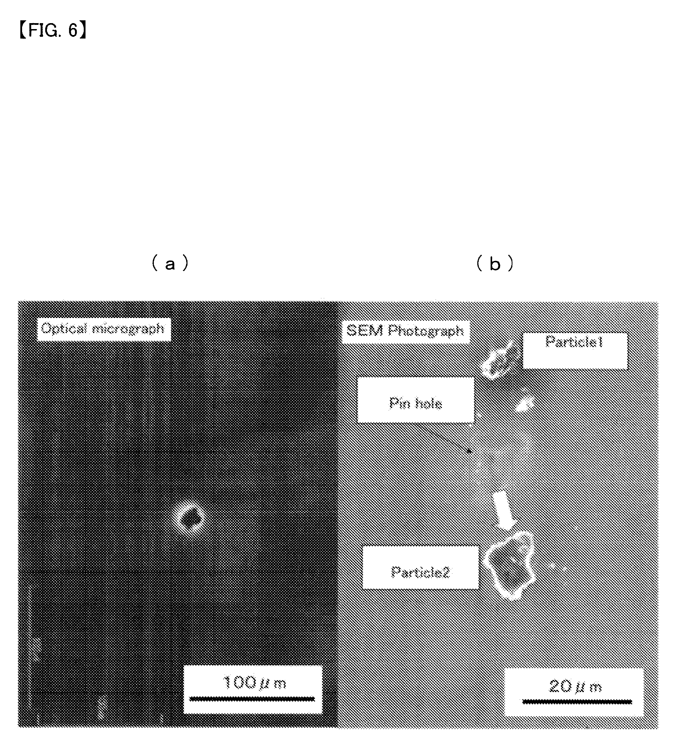

When a thin film formation surface is observed after a thin film is formed by sputter deposition or the like, a part where a thin film formation layer is not formed, a so-called film absent part is often recognized. An optical micrograph of the observed film absent part is shown as an example in Fig. 6 (a). Generation of the film absent part serves as a cause for lowering an optical characteristic and a yield of an optical filter. Thus, a manufacturing method of the optical filter for preventing the generation of the film absent part is desired.

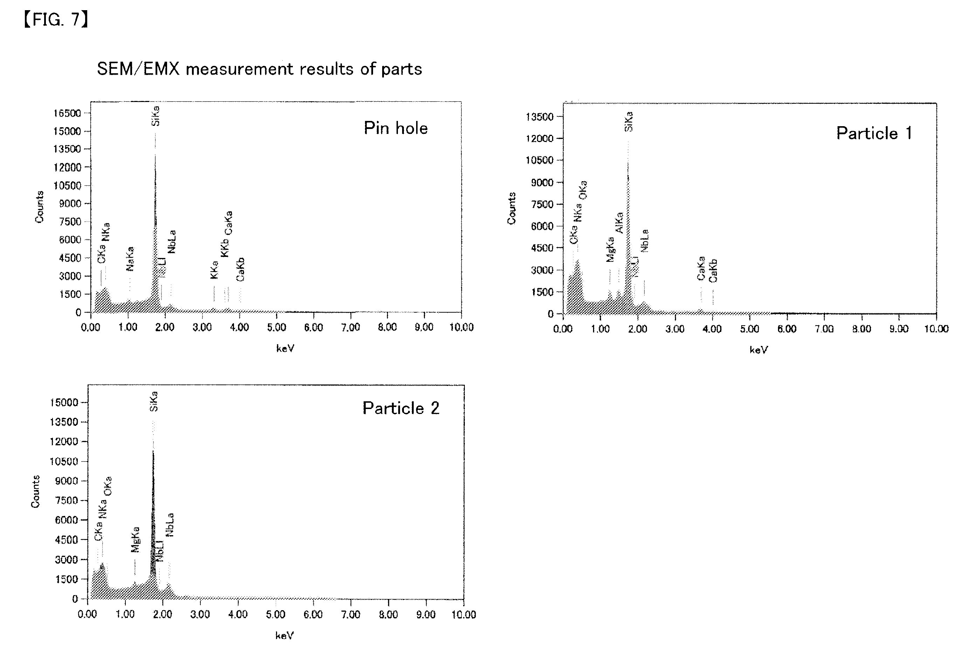

When the film absent part recognized on a surface of a substrate after the thin film is formed is observed in detail by a SEM (Scanning Electron Microscope), as shown in Fig. 6(b), particulate foreign substances (Particle 1, Particle 2) are sometimes not dropped off but held around the film absent part (Pin hole). Examples of analyses of the foreign substances (Particle 1, Particle 2) and the film absent part (Pin hole) by means of a SEM/EDX (Scanning Electron Microscope/Energy Dispersive X-ray spectroscope) are shown in Fig. 7. It is found that the foreign substances (Particle 1, Particle 2) recognized in the film absent part (Pin hole) contain elements such as Ca, Na, and K in addition to film materials (Nb, Si). Table 1 shows analysis results indicating presence/absence of the elements confirmed by the SEM/EDX.

**[Table 1]**

| | Na | Mg | Si | K | Ca | Nb |
|---|---|---|---|---|---|---|
| Pin hole | ○ | | ○ | ○ | ○ | ○ |
| Particle 1 | | ○ | ○ | | | ○ |
| Particle 2 | | ○ | ○ | | ○ | ○ |

As shown in Table 1, the foreign substances of the film absent part contain the elements such as Ca, Na, and K. Thus, it is thought that the foreign substances are adhered onto the film formation surface of the substrate in a cleaning step performed as a previous step of a thin film formation step. That is, it is estimated that the film absent part is generated by forming the thin film in a state where minerals of a cleaning liquid used in the cleaning step or detergent components are adhered onto the thin film formation surface of a glass substrate (hereinafter, referred to as the substrate).

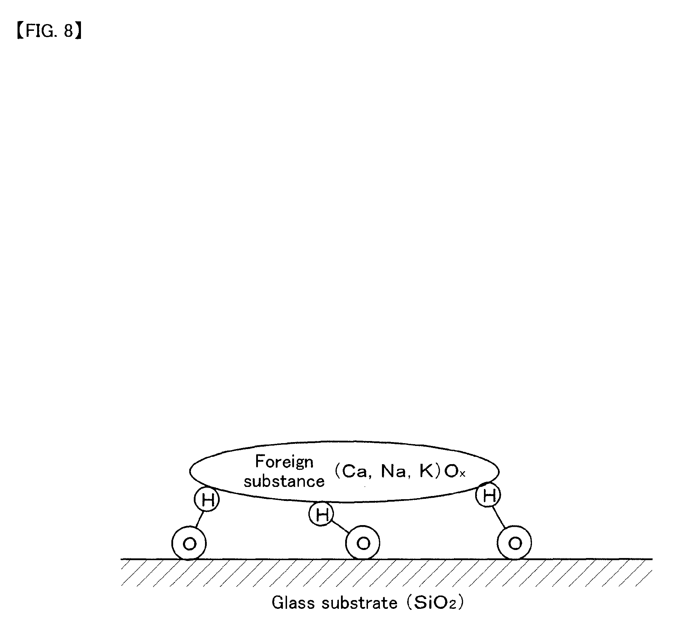

As a result of further investigating the film absent part and the foreign substances, it is found that: (A) an adhesion mode is such that adhesion force is so weak that the foreign substances are moved from the film absent part even with preparation at the time of SEM observation and irradiation of electron beams; and (B) since the film absent part is not recognized in a case where a vacuum heating treatment is performed between the cleaning step and the thin film formation step, the adhesion mode is such that the film absent part and the foreign substances are decomposed at about 200 to 300 °C. From the above knowledge, an obtained conclusion is that the foreign substances serving as a cause for generating the film absent part are mainly composed of an alkali metal element and an alkali earth metal element, and the foreign substances and the substrate are bonded to each other by OH bonds. Fig. 8 shows a schematic view of a state that the foreign substance and the substrate are bonded to each other through the OH bonds.

Meanwhile, in order to obtain a high quality film having no film absent part, there is a conventionally known method of irradiating ion beams to a substrate as a pre-treatment before a thin film is formed (for example, refer to Patent Document 1). By this pre-treatment, a part of remaining waste (a foreign substance) adhered on the substrate before the thin film is formed can be removed. As a treatment before and after a thin film is formed, there is a known method of plasma-treating a surface of a substrate (for example, refer to Patent Document 2).

Patent Document 1: Japanese Patent Application Publication No. 1994-116708
Patent Document 2: Japanese Patent Application Publication No. 2007-314835

### Disclosure of the Invention

### Problems to be Solved by the Invention

However, the thin film manufacturing method according to Patent Document 1 is a technique of cleaning a surface of the substrate by etching with the ion beams having as much directional motion energy as hundreds of eV to 1,000 eV. Thus, although the foreign substance on the surface of the substrate is removed, high-power ion beams are required. Therefore, it is not easy to apply the manufacturing method immediately to a sputter deposition method.
The thin film manufacturing method according to Patent Document 2 is a treatment for sustaining an excitation state of a sputtered substance, and a method performed before and after the thin film formation step. Thus, an object thereof is not to remove the foreign substance on the substrate. Therefore, as a cleaning method of the surface of the substrate, a stable effect cannot always be expected, and there is a fear that the generation of the film absent part generated by the above mode cannot be prevented.
It should be noted that in a case where the vacuum heating treatment is performed after the cleaning step, a deposition device provided with a heater or the like is required. Thus, there is a disadvantage in terms of cost.

An object of the present invention is to provide a manufacturing method of an optical filter capable of forming a thin film having favorable film quality by reliably removing a foreign substance adhered onto a surface of a substrate before the thin film is formed.

### Means for Solving the Problems

As a result of further studies for solving the above problems, the present inventors obtained new knowledge that a foreign substance adhered onto a surface of a substrate through OH bonds in a cleaning step can be eliminated by performing an oxygen plasma treatment to the substrate before a thin film formation step, and completed the prevent invention.

That is, with a manufacturing method of an optical filter in which a thin film is formed on a surface of a substrate, the above problems can be solved by performing a cleaning step for cleaning the substrate, a pre-treatment step for plasma-treating the surface of the substrate cleaned in the cleaning step by plasma of an oxygen gas, and a thin film formation step for forming the thin film on the surface of the substrate plasma-treated in the pre-treatment step.

In such a way, by performing the pre-treatment step for plasma-treating the surface of the substrate cleaned in the cleaning step by the plasma of the oxygen gas, and the thin film formation step for forming the thin film on the surface of the substrate plasma-treated in the pre-treatment step so as to eliminate the foreign substance adhered onto the surface of the substrate through bonds such as the OH bonds and CO bonds in the cleaning step before the thin film formation step, generation of a film absent part can be effectively prevented. Therefore, the manufacturing method of the optical filter capable of forming the thin film having the favorable film quality with no film absent part can be provided.

According to claim 2, the above problems are solved by a manufacturing method of an optical filter, including a cleaning step for cleaning a substrate, a pre-treatment step for plasma-treating a surface of the substrate cleaned in the cleaning step, and a thin film formation step for forming a thin film on the surface of the substrate plasma-treated in the pre-treatment step, wherein the thin film formation step is to perform a series of the following steps for a plurality of times including a sputtering step for sputtering a target made of at least one kind of metal in a thin film formation process area formed in a vacuum chamber so as to adhere a film material made of the metal onto the surface of the substrate, a substrate conveying step for conveying the substrate into a reaction process area formed at a position distant from the thin film formation process area in the vacuum chamber, and a reaction step for generating plasma of a reactive gas in a state where the reactive gas is introduced into the reaction process area and reacting the reactive gas and the film material, so as to generate a compound or an imperfect compound of the reactive gas and the film material, and the pre-treatment step is performed in the reaction process area where plasma of an oxygen gas is generated.

With the above configuration, since the thin film formation process area where the thin film formation step is performed and the reaction process area where the sputtering step is performed are separated at distant positions, the target and the reactive gas do not react so as to generate abnormal electric discharge. Thus, there is no need for increasing a temperature of the substrate so as to improve a reactive property unlike the conventional example, and reaction can be sufficiently performed at a low temperature. By performing the pre-treatment step in this reaction process area, a cost increase of a treatment device can be suppressed, and a treatment time can be shortened. Thus, the manufacturing method of the optical filter capable of being manufactured at low cost and forming the thin film having high film quality can be provided.

Specifically and preferably, as in claim 3, only the oxygen gas is introduced to the reaction process area in the pre-treatment step, and a flow rate of the oxygen gas introduced to the reaction process area in the pre-treatment step is greater than a flow rate of the oxygen gas introduced to the reaction process area in the thin film formation step.

With the above configuration, the substrate can be treated by the plasma containing high-density oxygen radicals. Thus, the foreign substance adhered onto the surface of the substrate through the OH bonds or the CO bonds in the cleaning step can be effectively removed within a short time. Thereby, the generation of the film absent part generated on a surface of the completed optical filter can be suppressed. Thus, the manufacturing method of the optical filter capable of forming the thin film having the favorable film quality while suppressing treatment cost can be provided.

According to claim 4, the above problems are solved by a manufacturing method of an optical filter, including a cleaning step for cleaning a substrate, a pre-treatment step for plasma-treating a surface of the substrate cleaned in the cleaning step, and a thin film formation step for forming a thin film on the surface of the substrate plasma-treated in the pre-treatment step, wherein the thin film formation step is to perform a series of the following steps for a plurality of times including a sputtering step for sputtering a target made of at least one kind of metal in a thin film formation process area formed in a vacuum chamber so as to adhere a film material made of the metal onto the surface of the substrate, a substrate conveying step for conveying the substrate into a reaction process area formed at a position distant from the thin film formation process area in the vacuum chamber, and a reaction step for generating plasma of a reactive gas in a state where the reactive gas is introduced into the reaction process area and reacting the reactive gas and the film material, so as to generate a compound or an imperfect compound of the reactive gas and the film material, and the pre-treatment step is performed by generating plasma of an oxygen gas in an oxygen plasma treatment area partitioned from both the thin film formation process area and the reaction process area while maintaining airtightness.

With the above configuration, the pre-treatment step can be performed in a load lock chamber partitioned from a thin film formation chamber in which the sputtering step and the reaction step are performed while maintaining the airtightness. Thus, regarding various conditions such as atmosphere, pressure and a temperature, conditions which are more suitable for the pre-treatment step can be set with high precision. Therefore, the manufacturing method of the optical filter capable of more efficiently removing the foreign substance can be provided. Even when treatment conditions are different between the pre-treatment step and the reaction step, there is no need for performing a changing operation of the treatment conditions. Thus, the manufacturing method of the optical filter for improving workability can be provided.

### Effect of the Invention

With the manufacturing method of the optical filter of the present invention, the foreign substance adhered onto the surface of the substrate in the cleaning step can be effectively eliminated before the thin film formation step. Thus, the manufacturing method of the optical filter capable of forming the thin film having the favorable film quality with hardly any film absent part can be provided.
Due to a little film absent part, a yield is high, and as a result, the manufacturing method of the optical filter capable of forming the thin film having an excellent film quality at low cost can be provided.

### Brief Description of the Drawings

[Fig. 1] An illustrative view in which a thin film formation device is seen from the upper side.
[Fig. 2] An illustrative view in which the thin film formation device of Fig. 1 is seen from the side.
[Fig. 3] An enlarged illustrative view showing a periphery of a thin film formation process area of the thin film formation device of Fig. 1.
[Fig. 4] An enlarged illustrative view showing a periphery of a reaction process area of the thin film formation device of Fig. 1.
[Fig. 5] A flowchart showing a flow of a manufacturing method of an optical filter according to a first embodiment of the present invention.
[Fig. 6] An optical micrograph and a SEM photograph of a film absent part.
[Fig. 7] Analysis results of the film absent part and a foreign substance by a SEM/EDX.
[Fig. 8] A schematic view of a state that the foreign substance and a substrate are bonded to each other through OH bonds.

### Explanation of Reference Characters

1: Thin film formation device
11: Vacuum chamber
11a: Opening
11A: Thin film formation chamber
11B: Load lock chamber
11C: Door
11D: Door
12: Partition wall
13: Rotation drum
13a: Substrate holding plate
13b: Frame
13c: Fastening tool
14: Partition wall
15a: Vacuum pump
15b: Vacuum pump
16a-1: Pipe
16a-2: Pipe
16b: Pipe
17: Motor
17a: Motor rotation shaft
18: Drum rotation shaft
20: Sputtering means
20A: Thin film formation process area
21a: Magnetron sputter electrode
21b: Magnetron sputter electrode
22a: Target
22b: Target
23: Transformer
24: AC power supply
30: Sputter gas supply means
31: Mass flow controller
32: Sputter gas tank
35a: Pipe
35b: Introduction port
35c: Pipe
60: Plasma generation means
60A: Reaction process area
61: Case body
61A: Antenna storing chamber
62: Dielectric plate
63: Antenna
64: Matching box
65: High frequency power supply
66: Grid
70: Reactive gas supply means
71: Oxygen gas tank
72: Mass flow controller
75a: Pipe
S: Substrate (base material)
V1: Valve
V2: Valve
V3: Valve
Z: Rotation shaft line
P1: Cleaning step
P2: Vacuuming step
P3: Pre-treatment step
P4: Sputtering step
P5: Reaction step
P6: Inspection step
P7: Substrate conveying step

### Best Modes for Carrying out the Invention

Hereinafter, one embodiment of the present invention will be described with reference to the drawings. It should be noted that members, arrangement and the like described below are only one example embodying the invention, and the present invention is not limited thereto. As a matter of course, the members, the arrangement and the like can be variously modified along the gist of the present invention.

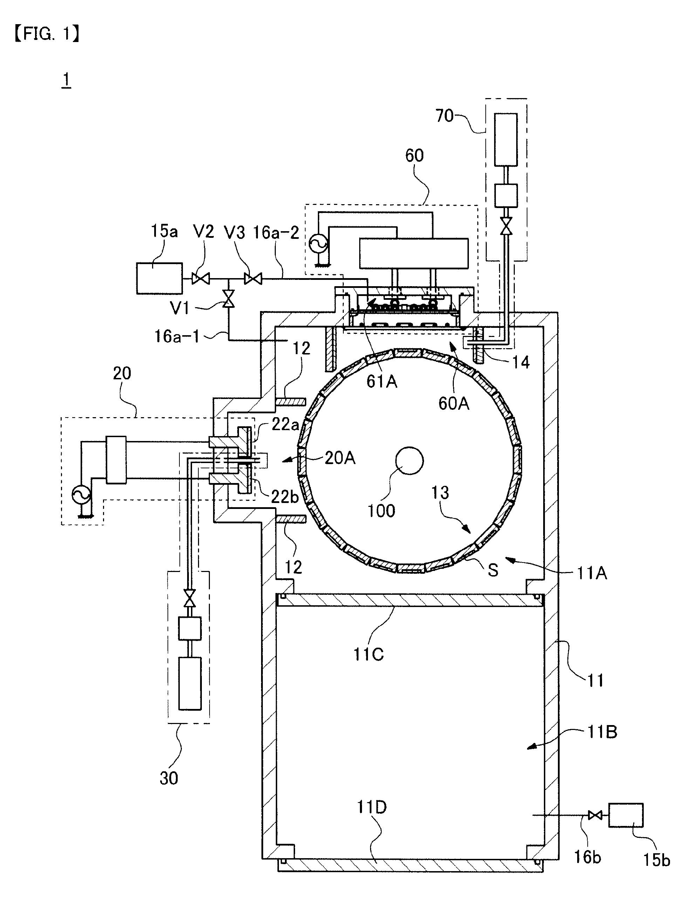

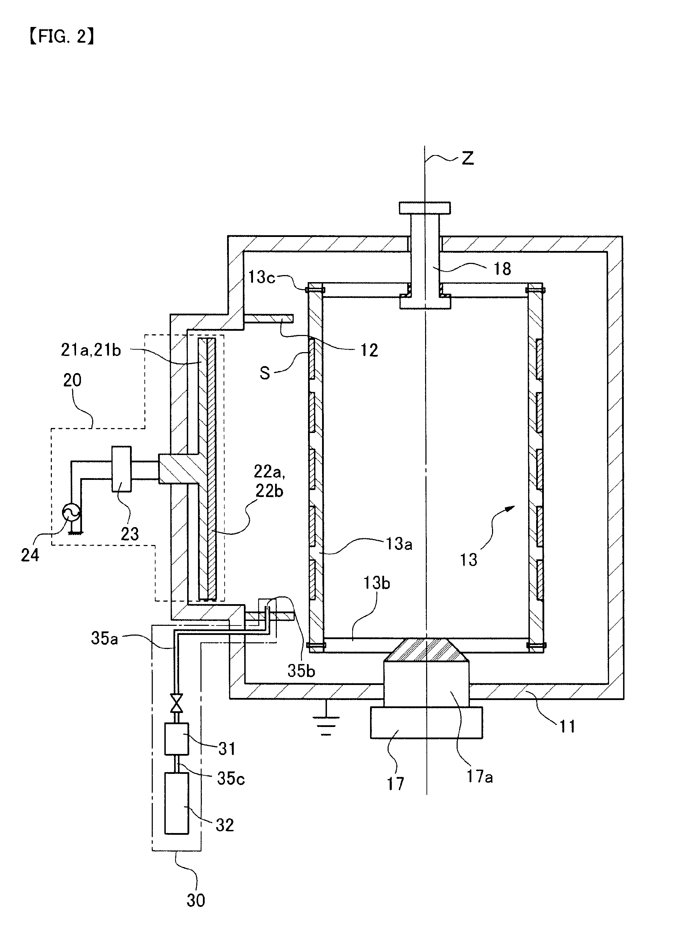

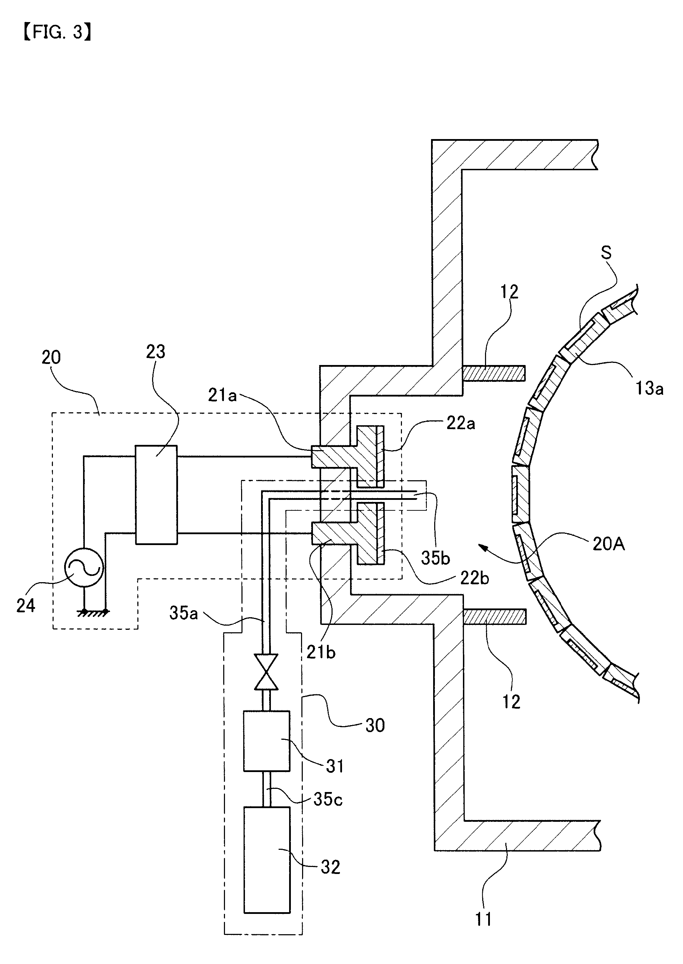

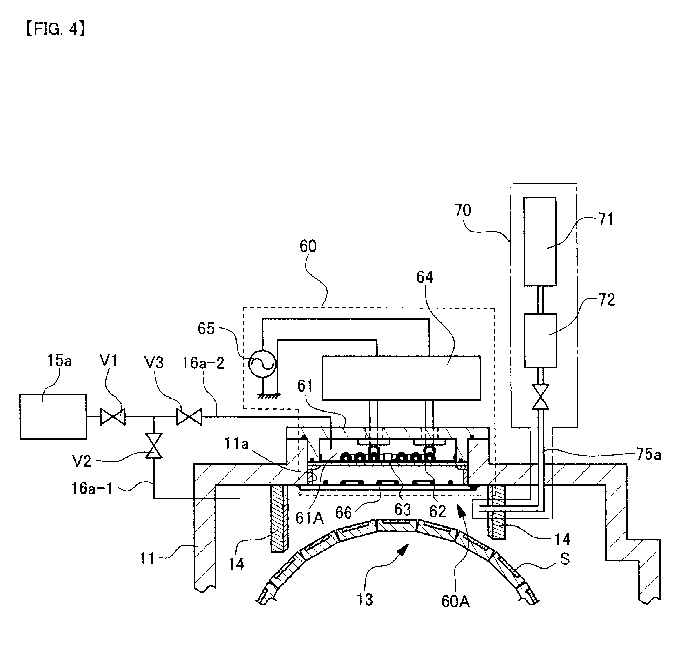

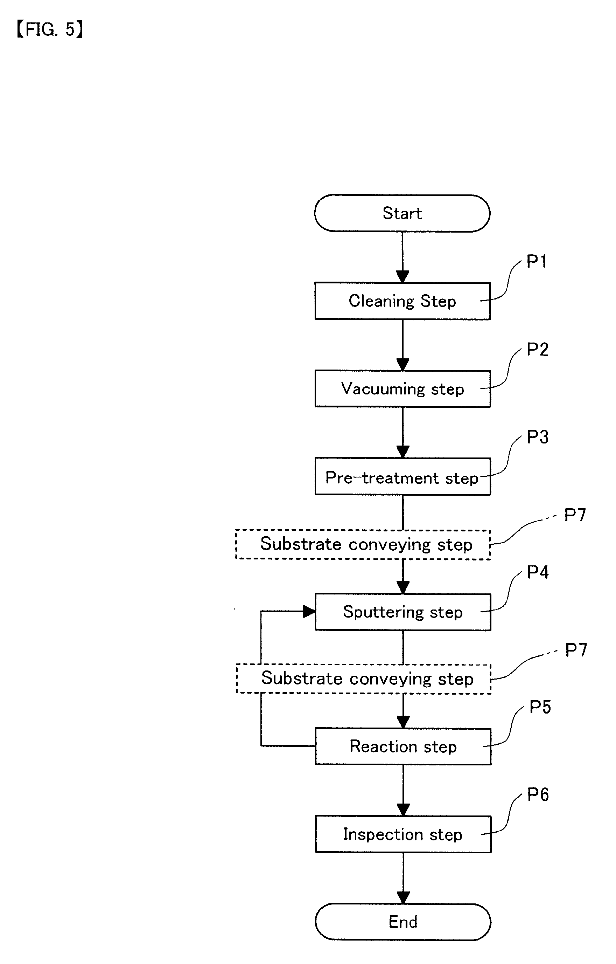

Figs. 1 to 4 are views for illustrating a thin film formation device used in a manufacturing method of an optical filter of the present invention. Fig. 1 is an illustrative view in which the thin film formation device is seen from the upper side, Fig. 2 is an illustrative view in which the thin film formation device of Fig. 1 is seen from the side, Fig. 3 is an enlarged illustrative view showing a periphery of a thin film formation process area of the thin film formation device of Fig. 1, and Fig. 4 is an enlarged illustrative view showing a periphery of a reaction process area of the thin film formation device of Fig. 1. Fig. 5 is a flowchart showing a flow of the manufacturing method of the optical filter according to one embodiment of the present invention.

In the present embodiment, the optical filter is manufactured by means of a thin film formation device 1 for performing magnetron sputtering serving as one example of sputtering. However, a thin film formation device for performing other known sputtering without using magnetron discharge such as dipole sputtering and ECR sputtering can also be used.
It should be noted that although an example that a film formation treatment is performed by a sputter deposition method will be described in the present embodiment, a film formation method after an oxygen plasma treatment (a pre-treatment step) before a film is formed may be an electron beam deposition method or a deposition method by resistance heating, or ion plating or a CVD deposition method, or the like. The pre-treatment step is not limited to the thin film formation device 1 described in the present embodiment but may be performed by a device capable of treating substrates S by oxygen plasma.

In the thin film formation device 1 of the present embodiment, after the pre-treatment step in which the substrates S are treated by the oxygen plasma, an intermediate thin film is formed on surfaces of the substrates S by a sputtering step for adhering a thin film which is considerably thinner than desired film thickness onto the surfaces of the substrates S, and a reaction step for performing treatments such as oxidation to this thin film so as to convert composition of the thin film. Then, by repeating the sputtering step and the reaction step for a plurality of times, a plurality of the intermediate thin films is laminated, so that a final thin film having the desired film thickness is formed on the surfaces of the substrates S.
Specifically, a step for forming the intermediate films whose average film thickness value is about 0.01 to 1.5 nm after conversion of the composition on the surfaces of the substrates S by the sputtering step and the reaction step is repeated for every rotation of a rotation drum, so that the final thin film having the desired film thickness of about a few nm to hundreds of nm is formed.

Hereinafter, the thin film formation device 1 used in the manufacturing method of the optical filter will be described.

As shown in Fig. 1, the thin film formation device 1 of the present embodiment has major constituent elements including a vacuum chamber 11, a rotation drum 13, a motor 17 (refer to Fig. 2), a sputtering means 20, a sputter gas supply means 30, a plasma generation means 60, and a reactive gas supply means 70.

It should be noted that in the figure, the sputtering means 20 and the plasma generation means 60 are shown by broken lines, and the sputter gas supply means 30 and the reactive gas supply means 70 are shown by chain lines.

It should be noted that although an example that niobium oxide (Nb₂O₅) and silicon oxide (SiO₂) having a Green reflex are alternately laminated as the thin film will be described in the present embodiment, other thin films such as an antireflection film may be applied, and as a matter of course, the manufacturing method can also be applied to formation of a thin film device such as a hydrophilic thin film and a semiconductor thin film.

The vacuum chamber 11 is made of stainless steel which is generally used in a known thin film formation device and formed into a hollow body in a substantially square shape. The interior of the vacuum chamber 11 is divided into a thin film formation chamber 11A and a load lock chamber 11B by a door 11C serving as an opening and closing door. A door storing chamber (not shown) storing the door 11C is connected on the upper side of the vacuum chamber 11. The door 11C opens and closes by sliding between the interior of the vacuum chamber 11 and the interior of the door storing chamber.

A door 11D for partitioning the load lock chamber 11B and the exterior of the vacuum chamber 11 is provided in the vacuum chamber 11. The door 11D opens and closes by sliding or pivoting. An exhaust pipe 16a-1 is connected to the thin film formation chamber 11A, and a vacuum pump 15a for exhausting the interior of the vacuum chamber 11 is connected to this pipe 16a-1. An opening is formed in the pipe 16a-1 in the interior of the vacuum chamber 11, and this opening is positioned between a thin film formation process area 20A and a reaction process area 60A in the interior of the vacuum chamber 11. Thereby, film materials scattered in the thin film formation process area 20A can be suctioned by the vacuum pump 15a. Thus, the film materials scattered from the thin film formation process area 20A are prevented from invading the reaction process area 60A so as to contaminate the plasma generation means 60, and adhering onto the surfaces of the substrates S positioned outside the thin film formation process area 20A so as to contaminate.
An exhaust pipe 16b is connected to the load lock chamber 11B, and a vacuum pump 15b for exhausting the interior of the vacuum chamber 11 is connected to this pipe 16b.

Since the thin film formation device 1 of the present embodiment is provided with such a load lock chamber 11B, the substrates S can be carried in and out in a state where a vacuum state in the thin film formation chamber 11A is maintained. Therefore, troublesomeness of exhausting the interior of the vacuum chamber 11 and providing the vacuum state for every time when the substrates S are carried out can be eliminated. Thus, a thin film formation treatment can be performed with high working efficiency.
It should be noted that although the vacuum chamber 11 of the present embodiment adopts a load lock method provided with the load lock chamber 11B, a single chamber method provided with no load lock chamber 11B can also be adopted. A multi-chamber method provided with a plurality of vacuum chambers capable of forming the thin films respectively independently in the vacuum chambers can also be adopted.

The rotation drum 13 is a tubular member for holding the substrates S that the thin film is formed on the surfaces thereof in the interior of the vacuum chamber 11, and has a function as a substrate holding means. As shown in Fig. 2, the rotation drum 13 has major constituent elements including a plurality of substrate holding plates 13a, a frame 13b, and fastening tools 13c for fastening the substrate holding plates 13a and the frame 13b.
The substrate holding plates 13a are flat plate shape members made of stainless steel and provided with a plurality of substrate holding holes for holding the substrates S in one row in plate surface center parts along the longitudinal direction of the substrate holding plates 13a. The substrates S are stored in the substrate holding holes of the substrate holding plates 13a, and fixed to the substrate holding plates 13a so as not to be dropped off by means of screw members or the like. Screw holes into which the fastening tools 13c described below are insertable are provided in plate surfaces in both ends in the longitudinal direction of the substrate holding plates 13a.

The frame 13b is made of stainless steel and formed by two annular members arranged on the upper and lower sides. The annular members of the frame 13b are respectively provided with screw holes at positions corresponding to the screw holes of the substrate holding plates 13a. The substrate holding plates 13a and the frame 13b are fixed by means of the fastening tools 13c including bolts and nuts. Specifically, fixing is performed by inserting the bolts into the screw holes of the substrate holding plates 13a and the frame 13b and fixing with the nuts.
It should be noted that although the rotation drum 13 in the present embodiment is formed into a polygonal column shape having a polygonal cross section with a plurality of the flat plate shape substrate holding plates 13a, the rotation drum is not limited to such a polygonal column shape but may be a cylindrical shape or a conical shape.

The substrates S are members made of materials such as glass. In the present embodiment, plate shape materials are used as the substrates S. However, a shape of the substrates S is not limited to such a plate shape but may be other shapes with which the thin film is formed on the surfaces such as a lens shape, a cylindrical shape, and a circular shape. The glass materials are materials made of silicon oxide (SiO₂), specifically quartz glass, soda-lime glass, borosilicate glass, and the like.

The materials of the substrates S are not limited to the glass but may be plastic resin or the like. Examples of the plastic resin include a resin material selected from the group consisting of polycarbonate, polyethylene terephthalate, polybutylene terephthalate, acrylonitrile-butadiene-styrene copolymer, nylon, polycarbonate-polyethylene terephthalate copolymer, polycarbonate-polybutylene terephthalate copolymer, acryl, polystyrene, polyethylene, and polypropylene, or a mixture of these materials with glass fiber and/or carbon fiber.

The rotation drum 13 installed in the interior of the vacuum chamber 11 is formed so as to be moved between the thin film formation chamber 11A and the load lock chamber 11B shown in Fig. 1. In the present embodiment, a rail (not shown) is installed on a bottom surface of the vacuum chamber 11, and the rotation drum 13 is moved along this rail. The rotation drum 13 is arranged in the interior of the vacuum chamber 11 so that a rotation shaft line Z in the cylinder direction of a cylinder (refer to Fig. 2) serves as the up and down direction of the vacuum chamber 11. At the time of attaching and detaching the substrate holding plates 13a to and from the frame 13b, the rotation drum 13 is conveyed to the load lock chamber 11B, and the substrate holding plates 13a are attached to and detached from the frame 13b in this load lock chamber 11B. Meanwhile, at the time of forming the thin film, the rotation drum 13 is conveyed to the thin film formation chamber 11A so as to be rotatable in the thin film formation chamber 11A.

As shown in Fig. 2, a center part in a lower surface of the rotation drum 13 is formed into a shape to be engaged with an upper surface of a motor rotation shaft 17a. The rotation drum 13 and the motor rotation shaft 17a are positioned so that a center shaft line of the motor rotation shaft 17a and a center shaft line of the rotation drum 13 correspond to each other, and coupled to each other by engaging both. A surface on the lower surface of the rotation drum 13 to be engaged with the motor rotation shaft 17a is formed by an insulating member. Thereby, abnormal electric discharge of the substrates S can be prevented. An O ring maintains airtightness between the vacuum chamber 11 and the motor rotation shaft 17a.

By driving the motor 17 provided in a lower part of the vacuum chamber 11 in a state where the vacuum state in the interior of the vacuum chamber 11 is maintained, the motor rotation shaft 17a is rotated. In accordance with this rotation, the rotation drum 13 coupled to the motor rotation shaft 17a is rotated around the rotation shaft line Z. Since the substrates S are held on the rotation drum 13, the substrates revolve due to the rotation of the rotation drum 13 taking the rotation shaft line Z as a revolving shaft.

A drum rotation shaft 18 is provided on an upper surface of the rotation drum 13, and the drum rotation shaft 18 is formed so as to be rotated in accordance with the rotation of the rotation drum 13. A hole part is formed on an upper wall surface of the vacuum chamber 11, and the drum rotation shaft 18 passes through this hole part and communicates with the exterior of the vacuum chamber 11. A bearing is provided on an inner surface of the hole part, so that the rotation of the rotation drum 13 can be smoothly performed. An O ring maintains the airtightness between the vacuum chamber 11 and the drum rotation shaft 18.

Next, the thin film formation process area 20A in which the thin film is formed on the surfaces of the substrates S, and the reaction process area 60A will be described. As shown in Fig. 1, partition walls 12 and partition walls 14 are uprightly provided at positions facing the rotation drum 13 on inner walls of the vacuum chamber 11. Both the partition walls 12 and the partition walls 14 in the present embodiment are members made of stainless steel as well as the vacuum chamber 11. Both the partition walls 12 and the partition walls 14 are formed by flat plate members arranged on the upper and lower sides and on the left and right sides respectively, and provided so as to protrude from inner wall surfaces of the vacuum chamber 11 toward to the rotation drum 13 and surround in four directions. Thereby, the thin film formation process area 20A and the reaction process area 60A are respectively partitioned in the interior of the vacuum chamber 11.

A side wall of the vacuum chamber 11 has a convex shape cross section protruding outward, and the sputtering means 20 is provided on a protruding wall surface. The thin film formation process area 20A is formed in an area which is enclosed by the inner wall surface of the vacuum chamber 11, the partition walls 12, an outer peripheral surface of the rotation drum 13, and the sputtering means 20. In the thin film formation process area 20A, a sputtering treatment for adhering the film materials onto the surfaces of the substrates S is performed.

A side wall of the vacuum chamber 11 which is distant from the thin film formation process area 20A by 90° relative to the rotation shaft of the rotation drum 13 also has a convex shape cross section protruding outward, and the plasma generation means 60 is provided on a protruding wall surface. The reaction process area 60A is formed in an area which is enclosed by the inner wall surface of the vacuum chamber 11, the partition walls 14, the outer peripheral surface of the rotation drum 13, and the plasma generation means 60. In the reaction process area 60A, the pre-treatment step for plasma-treating the surfaces of the substrates S before the thin film is formed, and the reaction step for reacting the film materials adhered onto the surfaces of the substrates S and plasma of a reactive gas are performed.
It should be noted that although the pre-treatment step is performed in the reaction process area 60A in the present embodiment, an oxygen plasma treatment device may be provided in the load lock chamber 11B, and an oxygen plasma treatment area is formed, so that the pre-treatment step is performed in the oxygen plasma treatment area in the load lock chamber 11B.

In the reaction step, when the rotation drum 13 is rotated by the motor 17, the substrates S held on the outer peripheral surface of the rotation drum 13 revolve and repeatedly move between positions facing the thin film formation process area 20A and positions facing the reaction process area 60A. Since the substrates S revolve in such a way, the sputtering treatment in the thin film formation process area 20A and a reaction treatment in the reaction process area 60A are successively and repeatedly performed, so that the thin film is formed on the surfaces of the substrates S.

### (Thin Film Formation Process Area 20A)

Hereinafter, the thin film formation process area 20A will be described.

As shown in Fig. 3, the sputtering means 20 is installed in the thin film formation process area 20A.

The sputtering means 20 is formed by a pair of targets 22a, 22b, a pair of magnetron sputter electrodes 21a, 21b holding the targets 22a, 22b, an AC power supply 24 for supplying electric power to the magnetron sputter electrodes 21a, 21b, and a transformer 23 serving as a power control means for adjusting a power amount from the AC power supply 24.

The wall surface of the vacuum chamber 11 protrudes outward, and the magnetron sputter electrodes 21a, 21b are arranged on the inner wall of this protruding part so as to pass through the side wall. The magnetron sputter electrodes 21a, 21b are fixed to the vacuum chamber 11 having ground potential through insulating members (not shown).

The targets 22a, 22b of the present embodiment are made by forming the film materials into a flat plate shape, and respectively held by the magnetron sputter electrodes 21a, 21b so as to face a side surface of the rotation drum 13 as described below. Although niobium (Nb) and silicon (Si) are used as the targets 22a, 22b in the present embodiment, other materials such as titanium (Ti) and tantalum (Ta) may be used. Since the present invention is to remove foreign substances adhered onto the substrates S before the film is formed, the materials for the film to be formed are not particularly limited.

The magnetron sputter electrodes 21a, 21b have structures in which a plurality of magnets are arranged in the predetermined direction. The magnetron sputter electrodes 21a, 21b are connected to the AC power supply 24 through the transformer 23, and formed so as to apply AC voltage of 1k to 100 kHz to both the electrodes. The magnetron sputter electrodes 21a, 21b respectively hold the targets 22a, 22b. The targets 22a, 22b are formed into a flat plate shape, and as shown in Fig. 2, installed so that the longitudinal direction of the targets 22a, 22b is parallel to the rotation shaft line Z of the rotation drum 13.

As shown in Fig. 3, the sputter gas supply means 30 for supplying a sputter gas such as argon is provided in a periphery of the thin film formation process area 20A. The sputter gas supply means 30 is provided with major constituent elements including a sputter gas tank 32 serving as a sputter gas storage means, pipes 35a, 35c serving as sputter gas supply passages, and a mass flow controller 31 serving as a sputter gas flow rate adjusting means for adjusting a flow rate of the sputter gas.
The sputter gas includes an inert gas such as argon and helium. In the present embodiment, an argon gas is used.

Both the sputter gas tank 32 and the mass flow controller 31 are provided in the exterior of the vacuum chamber 11. The mass flow controller 31 is connected to the single sputter gas tank 32 storing the sputter gas through the pipe 35c.

The mass flow controller 31 is connected to the pipe 35a, and one end of the pipe 35a passes through the side wall of the vacuum chamber 11 and extends in the vicinity of the targets 22a, 22b in the thin film formation process area 20A. As shown in Fig. 2, an end of the pipe 35a is arranged in the vicinity of a center in lower parts of the targets 22a, 22b, and in the end thereof, an introduction port 35b is opened toward a center in front surfaces of the targets 22a, 22b.

The mass flow controller 31 is a device for adjusting the flow rate of the gas, provided with major constituent elements including a inlet into which the gas from the sputter gas tank 32 flows, an outlet from which the sputter gas flows out to the pipe 35a, a sensor for detecting mass and the flow rate of the gas, a control valve for adjusting the flow rate of the gas, a sensor for detecting the mass and the flow rate of the gas flowing from the inlet, and an electronic circuit for controlling the control valve based on the flow rate detected by the sensor (all the elements are not shown). A desired flow rate can be set in the electronic circuit from the exterior.

The flow rate of the sputter gas from the sputter gas tank 32 is adjusted by the mass flow controller 31, and the sputter gas is introduced into the pipe 35a. The sputter gas flowing into the pipe 35a is introduced from the introduction port 35b to the front surfaces of the targets 22a, 22b arranged in the thin film formation process area 20A.

When the AC voltage is applied from the AC power supply 24 to the magnetron sputter electrodes 21a, 21b in a state where the sputter gas is supplied from the sputter gas supply means 30 to the thin film formation process area 20A and a periphery of the targets 22a, 22b becomes inert gas atmosphere, part of the sputter gas in the periphery of the targets 22a, 22b emit electrons so as to be ionized. Since the magnets arranged in the magnetron sputter electrodes 21a, 21b form a leakage magnetic field on surfaces of the targets 22a, 22b, the electrons go round in the magnetic field generated in the vicinity of the surfaces of the targets 22a, 22b while drawing a toroidal curve. Strong plasma is generated along trajectories of the electrons, and ions of the sputter gas are accelerated toward the plasma and bombarded with the targets 22a, 22b, so that atoms and particles (niobium atoms and niobium particles in a case where the targets 22a, 22b are niobium, and silicon atoms and silicon particles in a case of silicon) on the surfaces of the targets 22a, 22b are ejected. The niobium atoms (or the silicon atoms) and the niobium particles (or the silicon particles) are the film materials serving as the materials of the thin film to be adhered onto the surfaces of the substrates S, so that the thin film is formed.

### (Reaction Process Area 60A)

Next, the reaction process area 60A will be described. As described above, in the reaction process area 60A, the pre-treatment step for removing the foreign substances adhered onto the surfaces of the substrates S in a cleaning treatment by a plasma treatment before the thin film is formed is performed, and the reaction treatment is performed to the film materials adhered onto the surfaces of the substrates S in the thin film formation process area 20A, so that the thin film made of a compound or an imperfect compound of the film materials is formed.

As shown in Fig. 4, an opening 11a for installing the plasma generation means 60 is formed on the wall surface of the vacuum chamber 11 corresponding to the reaction process area 60A. A pipe 75a is connected to the reaction process area 60A. A mass flow controller 72 is connected to one end of the pipe 75a, and this mass flow controller 72 is further connected to an oxygen gas tank 71. Therefore, an oxygen gas can be supplied from the oxygen gas tank 71 into the reaction process area 60A. It should be noted that in addition to the oxygen gas, the argon gas or the like can be supplied into the reaction process area 60A according to need.

Wall surfaces of the partition walls 14 on the side facing the reaction process area 60A are coated with protection layers made of pyrolytic boron nitride. Further, a part of the inner wall surface of the vacuum chamber 11 facing the reaction process area 60 is also coated with a protection layer made of pyrolytic boron nitride. Pyrolytic boron nitride is coated onto the partition walls 14 and the inner wall surfaces of the vacuum chamber 11 by a pyrolyzing method utilizing a chemical vapor deposition method. Preferably, such protection layers are provided according to need.

The plasma generation means 60 is provided so as to face the reaction process area 60A. The plasma generation means 60 of the present embodiment has a case body 61, a dielectric plate 62, an antenna 63, a matching box 64, and a high frequency power supply 65.

The case body 61 is formed into a shape of closing the opening 11a formed on the wall surface of the vacuum chamber 11, and fixed by bolts (not shown) so as to close the opening 11a of the vacuum chamber 11. By fixing the case body 61 to the wall surface of the vacuum chamber 11, the plasma generation means 60 is attached to the wall surface of the vacuum chamber 11. In the present embodiment, the case body 61 is made of stainless.

The dielectric plate 62 is formed by a plate shape dielectric body. Although the dielectric plate 62 is made of quartz in the present embodiment, a material of the dielectric plate 62 may not only be quartz but also ceramics such as Al₂O₃. The dielectric plate 62 is fixed to the case body 61 by a fixing frame (not shown). By fixing the dielectric plate 62 to the case body 61, an antenna storing chamber 61A is formed in an area enclosed by the case body 61 and the dielectric plate 62.

The dielectric plate 62 fixed to the case body 61 is provided so as to face the interior of the vacuum chamber 11 (the reaction process area 60A) through the opening 11a. At this time, the antenna storing chamber 61A is separated from the interior of the vacuum chamber 11. That is, in a state where the antenna storing chamber 61A and the interior of the vacuum chamber 11 are partitioned by the dielectric plate 62, independent space is formed. In a state where the antenna storing chamber 61A and the exterior of the vacuum chamber 11 are partitioned by the case body 61, the independent space is formed. In the present embodiment, the antenna 63 is installed in the antenna storing chamber 61A formed as the independent space in such a way. It should be noted that O rings respectively maintain the airtightness between the antenna storing chamber 61A and the interior of the vacuum chamber 11 and between the antenna storing chamber 61A and the exterior of the vacuum chamber 11.

In the present embodiment, a pipe 16a-2 diverges from the pipe 16a-1. This pipe 16a-2 is connected to the antenna storing chamber 61A, and has a role as an exhaust tube at the time of exhausting the interior of the antenna storing chamber 61A so that the vacuum state is produced.

In the pipe 16a-1, valves V1, V2 are provided at positions communicating with the interior of the vacuum chamber 11 from the vacuum pump 15a. In the pipe 16a-2, a valve V3 is provided at a position communicating with the interior of the antenna storing chamber 61A from the vacuum pump 15a. By closing any of the valves V2, V3, movement of the gas between the interior of the antenna storing chamber 61A and the interior of the vacuum chamber 11 is blocked. Pressure of the interior of the vacuum chamber 11 and pressure of the interior of the antenna storing chamber 61A are measured by a vacuum gauge (not shown).

In the present embodiment, the thin film formation device 1 is provided with a control device (not shown). Outputs of the vacuum gauge are inputted to this control device. The control device has functions of controlling exhaust by the vacuum pump 15a based on inputted measurement values of the vacuum gauge, and adjusting vacuum degrees of the interior of the vacuum chamber 11 and the interior of the antenna storing chamber 61A. In the present embodiment, since the control device controls opening and closing of the valves V1, V2, V3, the interior of the vacuum chamber 11 and the interior of the antenna storing chamber 61A can be exhausted at the same time or independently from each other.

The antenna 63 is a means for receiving supply of the electric power from the high frequency power supply 65 so as to generate an induction electric field in the interior of the vacuum chamber 11 (the reaction process area 60A), and generating the plasma in the reaction process area 60A. The antenna 63 of the present embodiment is provided with a cylindrical shape main body portion made of copper, and a coat layer made of silver for coating a surface of the main body portion. That is, the main body portion of the antenna 63 is made of copper which is inexpensive and easily-processible with low electric resistance and formed into a circular-tube shape, and the surface of the antenna 63 is coated with silver with lower electric resistance than copper. Thereby, by reducing impedance of the antenna 63 relative to a high frequency so that an electric current efficiently flows through the antenna 63, efficiency in generation of the plasma is increased.
With the thin film formation device 1 of the present embodiment, the AC voltage at a frequency of 1 to 27 MHz is applied from the high frequency power supply 65 to the antenna 63, so that the plasma of the reactive gas is generated in the reaction process area 60A.

The antenna 63 is connected to the high frequency power supply 65 through the matching body 64 storing a matching circuit. A variable capacitor (not shown) is provided in the matching box 64.
The antenna 63 is connected to the matching box 64 through a conducting wire portion. The conducting wire portion is made of the same material to the antenna 63. An insertion hole into which the conducting wire portion is inserted is formed in the case body 61. The antenna 63 on the inside of the antenna storing chamber 61A and the matching box 64 on the outside of the antenna storing chamber 61A are connected to each other through the conducting wire portion inserted into the insertion hole. A sealing member is provided between the conducting wire portion and the insertion hole, so that the airtightness is maintained on the inside and the outside of the antenna storing chamber 61A.

A grid 66 serving as an ion extinguishing means is provided between the antenna 63 and the rotation drum 13. The grid 66 is to extinguish part of the ions generated in the antenna 63 and part of the electrons. The grid 66 is a hollow member formed by a conductive body which is earthed. In order to make a coolant (such as cooling water) flow into the interior of the grid 66 formed by the hollow member, a hosepipe (not shown) for supplying the coolant is connected to an end of the grid 66.

The reactive gas supply means 70 is provided in the interior and a periphery of the reaction process area 60A. In the present embodiment, the reactive gas supply means 70 is provided with major constituent elements including the oxygen gas tank 71 storing the oxygen gas serving as the reactive gas, the mass flow controller 72 for adjusting the flow rate of the oxygen gas supplied from the oxygen gas tank 71, and the pipe 75a for introducing the reactive gas to the reaction process area 60A. In a case where the oxygen gas and the argon gas are mixed and introduced, a supply means for the argon gas is provided, and introduction amounts of the oxygen gas and the argon gas can be adjusted according to need.
It should be noted that similar devices to the sputter gas tank 32 and the mass flow controller 31 of the thin film formation process area 20A can be adopted for the oxygen gas tank 71 and the mass flow controller 72.
The reactive gas is not limited to the oxygen gas but may be a nitrogen gas, a fluorine gas, an ozone gas, or the like.

When the electric power is supplied from the high frequency power supply 65 to the antenna 63 in a state where the oxygen gas is introduced from the oxygen gas tank 71 to the reaction process area 60A through the pipe 75a, the plasma is generated in an area facing the antenna 63 in the reaction process area 60A, and the reaction treatment is performed to the film materials and the like, so as to produce oxide or imperfect oxide.
Specifically, in the pre-treatment step, bonds of the substrates S and the foreign substances are oxidized so as to be decomposed. In the reaction step, when the plasma of the oxygen gas introduced from the reactive gas supply means 70 is generated, niobium (Nb) and silicon (Si) serving as the film materials are oxidized by oxygen radicals generated in the plasma, so as to produce niobium oxide (Nb₂O₅) and silicon oxide (SiO₂) serving as perfect oxide of niobium and silicon, or imperfect oxide (NbₓO_{y}, SiOₓ (0 < x < 2, and 0 < y < 5)).
The oxygen radicals indicate more active radicals than oxygen molecules such as O₂₊ (oxygen molecule ions), O (atomic oxygen), and O* (oxygen radicals in which core electrons are excited).

The thin film formation device 1 of the present embodiment is characterized by a point that the thin film formation process area 20A in which the film materials are supplied by sputtering in such a way, and the reaction process area 60A in which the film materials and the reactive gas react are formed and separated at distant positions in the vacuum chamber 11.
In a conventional and general reactive sputtering device, the reactive gas and the film materials react in the thin film formation process area 20A in which the sputtering is performed. Thus, since the targets 22a, 22b and the reactive gas are brought into contact and react with each other, there is a disadvantage that the abnormal electric discharge is generated in the targets 22a, 22b. Therefore, there is a need for suppressing the reaction of the targets 22a, 22b and the reactive gas so as to prevent the generation of the abnormal electric discharge by reducing a supply amount of the reactive gas or decreasing generation density of the plasma. In this case, the film materials adhered onto the substrates S and the reactive gas do not easily sufficiently react. Therefore, there is a need for increasing a temperature of the substrates S in order to improve a reactive property.

Meanwhile, with the thin film formation device 1 of the present embodiment, since the thin film formation process area 20A and the reaction process area 60A are separated at the distant positions, the targets 22a, 22b and the reactive gas do not react so as to generate the abnormal electric discharge. Therefore, there is no need for increasing the temperature of the substrates S so as to improve the reactive property unlike the conventional example, and reaction can be sufficiently performed at a low temperature. Thereby, the reaction can be sufficiently performed to the substrates S made of glass materials and plastic materials having low heat resistance, so that the thin film having good film quality can be formed.

The thin film formation device 1 of the present embodiment is not provided with a temperature control means for controlling the temperature of the substrates S. However, even without the temperature control means, since there is no need for increasing the temperature of the substrates S for the above reason, the thin film can be formed at a low temperature of 100 °C or less.
It should be noted that, needless to say, the temperature control means for controlling the temperature of the substrates S can be provided so as to make the temperature of the substrates S to be a predetermined temperature. In this case, preferably, the temperature control means is controlled so that the temperature becomes a lower temperature than a heat resistance temperature of the substrates S. Specifically and preferably, a heating means for increasing the temperature and a cooling means for lowering the temperature are both provided, and a temperature sensor is provided at a position where the substrates S are arranged, so that the temperature control means is feedback-controlled based on the temperature detected by this temperature sensor.

Next, based on Fig. 5, the manufacturing method of the optical filter for forming the thin film made of niobium oxide (Nb₂O₅) and silicon oxide (SiO₂) on the surfaces of the substrates S will be described.
A manufacturing step for the optical filter according to the present embodiment includes a cleaning step P1, a vacuuming step P2, a pre-treatment step P3, and a thin film formation step including a sputtering step P4 and a reaction step P5. A substrate conveying step P7 for conveying the substrates to areas where the treatments are respectively performed is applied between the pre-treatment step P3, the sputtering step P4, and the reaction step P5. Further, according to need, an inspection step P6 for checking defects such as film absence of the optical filter after the film is formed is performed.

### (Cleaning Step P1)

The cleaning step P1 is performed by successively treating the substrates S in a cleaning line in which a cleaning tank, tap water tanks, pure water tanks, and a hot air tank are arranged in series.

The cleaning tank is a liquid tank of about PH8 including a mildly alkaline detergent solution. Ultrasonic cleaning is performed to the substrates S soaked in this cleaning tank. After finishing the cleaning in the cleaning tank, the substrates are successively soaked in the tap water tanks and the pure water tanks so as to clean a cleaning liquid adhered in the cleaning tank. The ultrasonic cleaning is also performed in the tap water tanks and the pure water tanks. Since one to three the tap water tanks and the pure water tanks are provided respectively, a high cleaning effect can be obtained. The present embodiment comprises of two tap water tanks and three the pure water tanks. After cleaning in the pure water tanks, the substrates S are sent to the hot air tank and dried. In the hot air tank, the substrates S are dried by hot air through a HEPA filter (High Efficiency Particulate Air Filter). Treatment times in the tanks in the cleaning line are respectively about two to five minutes.

It should be noted that many foreign substances serving as a cause for generating a film absent part are thought to be minerals of the cleaning liquid used in this cleaning step or detergent components adhered onto the thin film formation surfaces of the substrates S through OH bonds.

### (Vacuuming Step P2)

Next, the substrates S are set in the rotation drum 13 on the outside of the vacuum chamber 11, and stored in the load lock chamber 11B of the vacuum chamber 11. The rotation drum 13 is moved to the thin film formation chamber 11A along the rail (not shown). The vacuum chamber 11 is sealed in a state where the door 11C and the door 11D are closed, and the interior of the vacuum chamber 11 is made to be a high vacuum state of about 10-1 to 10-5 Pa by means of the vacuum pump 15a.

### (Substrate Conveying Step P7)

Next, the rotation drum 13 is rotated, so that the substrates S are conveyed from the load lock chamber 11B to the reaction process area 60A. The substrates S are consecutively conveyed between the reaction process area 60A in which the sputtering step P4 described below is performed and the thin film formation process area 20A in which the reaction step P5 is performed.

It should be noted that before the substrates S are conveyed from the load lock chamber 11B to the reaction process area 60A, the AC voltage is applied from the high frequency power supply 65 to the antenna 63 in a state where the oxygen gas, and the argon gas according to need, are introduced from the reactive gas supply means 70 to the interior of the reaction process area 60A, so that the plasma of the oxygen gas is generated in the interior of the reaction process area 60A for preparation for performing the pre-treatment step P3.

### (Pre-treatment Step P3)

Since the plasma of the oxygen gas is generated in the interior of the reaction process area 60A, the substrates S conveyed to the reaction process area 60A are plasma-treated. Time of the pre-treatment step P3 is an appropriate time within a range of about 1 to 30 minutes in accordance with the flow rate of the oxygen gas. Similarly, the flow rate of the oxygen gas is appropriately determined within a range of about 70 to 500 sccm, and the electric power supplied from the high frequency power supply 65 is appropriately determined within a range of 1.0 to 5.0 kW. In order to stably generate the plasma of the oxygen gas, pressure of the oxygen gas introduced to the reaction process area 60A (thin film formation pressure) is preferably about 0.3 to 0.6 Pa. The flow rate of the oxygen gas can be adjusted by the mass flow controller 72, and the electric power supplied from the high frequency power supply 65 can be adjusted by the matching box 64.

In the pre-treatment step P3, in order to prevent that the surfaces of the targets 22a, 22b are oxidized by the oxygen gas flowing from the reaction process area 60A into the thin film formation process area 20A, the argon gas is introduced into the thin film formation process area 20A. A flow rate of the argon gas is generally about 200 to 1, 000 sccm. Since the electric power is not supplied from the AC power supply 24 to the magnetron sputter electrodes 21a, 21b in this pre-treatment step P3, the targets 22a, 22b are not sputtered.
The OH bonds for bonding the foreign substances adhered onto the surfaces of the substrates in the cleaning step P1 to the surfaces of the substrates react to the plasma (the radicals) of the oxygen gas and cut off by this pre-treatment step P3. Thus, the foreign substances are eliminated from the surfaces of the substrates. In addition to the OH bonds, for example, CO bonds are also bonds for adhering the foreign substances onto the surfaces of the substrates. By the oxygen plasma treatment, however, C of the CO bonds can react to the oxygen radicals, so that the bonds can be decomposed. That is, as well as a case of the OH bonds, the pre-treatment step P3 also has an effect for removing the foreign substances adhered through the CO bonds.

### (Sputtering Step P4)

After finishing the pre-treatment step P3, the electric power is supplied from the AC power supply 24 to the magnetron sputter electrodes 21a, 21b in a state where the argon gas is introduced from the sputter gas supply means 30 into the thin film formation process area 20A, so that the targets 22a, 22b are sputtered. The flow rate of the argon gas is set to be an appropriate flow rate within a range of about 200 to 1,000 sccm. In this state, the rotation drum 13 is rotated and the substrates S after finishing the pre-treatment step P3 are conveyed to the thin film formation process area 20A, so that niobium (Nb) or silicon (Si) serving as the film materials is deposited on the surfaces of the substrates S.

It should be noted that a moving type or rotating type shielding plate may be provided between the rotation drum 13 and the targets 22a, 22b, so as to start and stop the sputtering step P4. In this case, the shielding plate is arranged at a shielding position where the film materials moving from the targets 22a, 22b do not reach the substrates S before starting the sputtering step P4, and moved to a non-shielding position where the film materials moving from the targets 22a, 22b reach the substrates S at the time of starting the sputtering step P4.

### (Reaction Step P5)

Next, the rotation drum 13 is rotated, so that the substrates S are conveyed to the reaction process area 60A. Since the plasma of the oxygen gas is generated in the interior of the reaction process area 60A, niobium (Nb) or silicon (Si) of the film materials adhered onto the surfaces of the substrates S in the sputtering step P4 reacts to the oxygen gas so as to be oxidized. In the present embodiment, the flow rate of the oxygen gas introduced at the time of plasma-treating in the pre-treatment step P3 is set to be greater than a flow rate of the oxygen gas introduced at the time of plasma-treating in the reaction step P5.

In such a way, the plasma respectively suitable for the pre-treatment step P3 and the reaction step P5 can be generated. Specifically, by increasing the flow rate of the oxygen gas introduced in the pre-treatment step P3, the bonds of the foreign substances and the substrates S can be efficiently cut off within a short time.

Aplace where the pre-treatment step P3 is performed and a place where the reaction step P5 is performed are not different areas in the vacuum chamber 11 but the reaction process area 60A is an area shared by both. Therefore, there is no need for providing two places where the pre-treatment step P3 and the reaction step P5 are performed in the interior of the vacuum chamber 11. Thus, a device configuration of the thin film formation device 1 can be simplified, so that cost required for forming the thin film can be reduced.

It should be noted that the oxygen plasma treatment area in which the oxygen plasma treatment device is attached may be provided in the load lock chamber 11B, so that the pre-treatment step P3 is performed in the oxygen plasma treatment area in the load lock chamber 11B. In this case, even when treatment conditions are different between the pre-treatment step P3 and the reaction step P5, there is no need for performing a troublesome changing operation of the treatment conditions. Thus, workability is improved. The pre-treatment step P3 can be performed in the load lock chamber 11B partitioned from the thin film formation chamber 11A while maintaining the airtightness. Thus, regarding various conditions such as atmosphere, the pressure and the temperature, conditions which are more suitable for the pre-treatment step P3 can be set. Therefore, the foreign substances can be more efficiently removed.

By continuously rotating the rotation drum 13 and successively repeating the sputtering step P4 and the reaction step P5, a plurality of the intermediate thin films is laminated, so that the final thin film having the desired film thickness is formed. This step corresponds to the thin film formation step (P4, P5) of the present invention.
It should be noted that the thin film formation step (P4, P5) is not limited to the above magnetron sputtering method but other thin film formation method.

### (Inspection Step P6)

When the above steps up to the thin film formation step are finished, the rotation of the rotation drum 13 is stopped, the vacuum state in the interior of the vacuum chamber 11 is released, and the rotation drum 13 is taken out from the vacuum chamber 11. The substrate holding plates 13a are detached from the frame 13b, so that the substrates S are collected. With the above steps, manufacturing of the optical filter of the present embodiment is completed.

In the inspection step P6, a surface of this manufactured optical filter is inspected with a magnifying glass, by visual observation, or with an automatic inspection machine for abnormality of a film formation surface such as the film absent part. In the present embodiment, size of the used substrates S (50 × 50 × 1t (mm)) is fixed. Thus, inspection results regarding the film absent part are recorded as the number of the film absent part detected for each of the substrates S.

With the manufacturing method of the optical filter of the present invention, the foreign substances adhered onto the surfaces of the substrates through the OH bonds in the cleaning step are eliminated before the thin film formation step, so that the generation of the film absent part can be prevented. Thus, the manufacturing method is preferably used in manufacturing of a high quality optical filter having high uniformity.
The oxygen plasma treatment also has an effect for removing the foreign substances adhered onto the substrates not through the OH bonds. That is, this is because the active oxygen radicals decompose the bonds of the substrates S and the foreign substances. For example, even in a case of the bonds based on CO, C of the CO bonds is oxidized by the oxygen radicals in the plasma. Thus, the bonds for adhering the foreign substances onto the substrates S are decomposed, so that the foreign substances can be removed.
In such a way, with the manufacturing method of the optical filter of the present invention, the generation of the film absent part serving as the defect can be prevented. Thus, the yield is high, and as a result, the optical filter can be manufactured at low cost.

### Examples

Next, examples in which the optical filter is actually manufactured by the manufacturing method of the optical filter of the present invention will be described.

### (First to Sixth Examples)

A thin film formed by a laminated film of niobium oxide (Nb₂O₅) and silicon dioxide (SiO₂) was formed on the surfaces of the substrates S by means of the thin film formation device 1 shown in Fig. 1. As the substrates S, D263 glass (manufactured by SCHOTT AG) serving as glass substrates prepared to have size of 50 × 50 × 1t (mm) was used. Several different conditions were adopted as various conditions such as the flow rate of the gas in the steps of the pre-treatment step P3 and the thin film formation step (P4, P5) as shown below.

### Kind of thin film: 6 layers/ 600 nm

### [Pre-treatment Step P3]

Time of pre-treatment step P3: 15, 30 minutes (2 conditions) Power amount supplied from high frequency power supply 65 to antenna 63: 3.0 kW (1 condition)

Flow rate of argon gas introduced to thin film formation process area 20A (TG-Ar): 500 sccm (1 condition)

Flow rate of oxygen gas introduced to reaction process area 60A (RS-O₂): 0, 200, 400 sccm (3 conditions)

Flow rate of argon gas introduced to reaction process area 60A (RS-Ar): 0, 200, 500 sccm (3 conditions)

### [Thin Film Formation Step (P4, P5)]

### Time of thin film formation step (P4, P5) : 30 minutes in total (1 condition)

Power amount supplied from high frequency power supply 65 to antenna 63: 3.0 kW (1 condition)

Flow rate of argon gas introduced to thin film formation process area 20A (TG-Ar): 150 sccm (1 condition)

Flow rate of oxygen gas introduced to reaction process area 60A (RS-O₂): 80 sccm (1 condition)

Flow rate of argon gas introduced to reaction process area 60A (RS-Ar): 0 sccm (1 condition)

Under the above implementation conditions, the flow rate of the argon gas introduced to the thin film formation process area 20A (TG-Ar), the flow rate of the oxygen gas introduced to the reaction process area 60A (RS-O₂), the flow rate of the argon gas introduced to the reaction process area 60A (RS-Ar), and the time of the pre-treatment step P3 (a pre-treatment time) are put in Table 2. It should be noted that the number of the film absent part confirmed in the inspection step P6 is also put in Table 2. It should be noted that since the film can be formed on four substrates S by one treatment, the number of the film absent part is a value serving as an average of the numbers of the film absent parts confirmed in the four substrates S treated in the same batch.

### (First Comparative Example)

In a first comparative example, conditions of the pre-treatment step P3 and conditions of the thin film formation step (P4, P5) are the same treatment conditions. The conditions are shown in Table 2 together. It should be noted that a counting method of the substrates S and the number of the film absent part is the same as the above examples.

### Kind of thin film: 6 layers/ 600 nm

### [Pre-treatment Step P3]

Time of pre-treatment step P3: 1 minute (1 condition) Power amount supplied from high frequency power supply 65 to antenna 63: 3.0 kW (1 condition)

Flow rate of argon gas introduced to thin film formation process area 20A (TG-Ar): 150 sccm (1 condition)

Flow rate of oxygen gas introduced to reaction process area 60A (RS-O₂): 80 sccm (1 condition)

Flow rate of argon gas introduced to reaction process area 60A (RS-Ar): 0 sccm (1 condition)

### [Thin Film Formation Step (P4, P5)]

### Time of thin film formation step (P4, P5) : 30 minutes in total (1 condition)

Power amount supplied from high frequency power supply 65 to antenna 63: 3.0 kW (1 condition)

Flow rate of argon gas introduced to thin film formation process area 20A (TG-Ar): 150 sccm (1 condition)

Flow rate of oxygen gas introduced to reaction process area 60A (RS-O₂): 80 sccm (1 condition)

Flow rate of argon gas introduced to reaction process area 60A (RS-Ar): 0 sccm (1 condition)

**[Table 2]**

| | TG-Ar [sccm] | RS-O₂ [sccm] | RS-Ar [sccm] | Pre-treatment step P3 treatment time [min] | Number of film absent part |
|---|---|---|---|---|---|
| Example 1 | 500 | 200 | 0 | 30 | 2 |
| Example 2 | 500 | 0 | 200 | 30 | 14 |
| Example 3 | 500 | 0 | 500 | 30 | 10 |
| Example 4 | 500 | 200 | 500 | 30 | 17 |
| Example 5 | 500 | 200 | 0 | 15 | 6 |
| Example 6 | 500 | 400 | 0 | 15 | 1 |
| Comparative Example 1 | 150 | 80 | 0 | 1 | 12 |

From Table 2, it is found that the number of the film absent part is low in the first, fifth and sixth examples in comparison to other conditions. It is estimated that this is because the plasma treatment is performed to the substrates S in the reaction process area 60A in the pre-treatment step P3, and the foreign substances adhered onto the substrates S are removed by the oxygen radicals in the plasma.
Particularly, in the first and sixth examples, the confirmed number of the film absent part is reduced to 1 to 2 points, which is suppressed to 1/12 to 1/6 in comparison to the comparative example. From this, the conditions of the pre-treatment step P3 in the first and sixth examples are effective for removing the foreign substances.

Since only the oxygen gas is introduced to the reaction process area 60A in the first, fifth and sixth examples, it is estimated that high density of the oxygen radicals in the plasma in the pre-treatment step P3 is a reason for producing a considerable effect for removing the foreign substances.
In the first and sixth examples in which a remarkable effect for removing the foreign substances is recognized, in comparison to the treatment conditions of the pre-treatment step P3 in the fifth example, frequency that the foreign substances are exposed to the radicals of the oxygen gas is high.
Further, in the sixth example in which the introduction amount of the oxygen gas (partial pressure of the oxygen gas) of the reaction process area 60A is high, a similar effect is obtained within a short time in comparison to the first example. From these, it is estimated that by increasing the introduction amount of the oxygen gas (the partial pressure of the oxygen gas) of the reaction process area 60A, the treatment time required for the pre-treatment step P3 can be shortened.

That is, by exposing the substrates S to the plasma of the oxygen gas in the pre-treatment step P3, the foreign substances adhered onto the surfaces of the substrates S in the cleaning step P1 can be effectively removed. Thereby, the generation of the film absent part generated on the surface of the completed optical filter can be suppressed, so that the high quality optical filter having excellent film quality can be obtained.
By changing the introduction amount of the oxygen gas (the partial pressure of the oxygen gas) of the reaction process area 60A, the treatment time required for the pre-treatment step P3 can be adjusted. Thereby, the pre-treatment step P3 can be performed in a desired treatment time, so that the optical filter can be efficiently manufactured.

## Claims

1. A manufacturing method of an optical filter in which a thin film is formed on a surface of a substrate, comprising:
a cleaning step for cleaning the substrate;
a pre-treatment step for plasma-treating the surface of the substrate cleaned in the cleaning step by plasma of an oxygen gas; and
a thin film formation step for forming the thin film on the surface of the substrate plasma-treated in the pre-treatment step.

2. A manufacturing method of an optical filter, comprising:
a cleaning step for cleaning a substrate;
a pre-treatment step for plasma-treating a surface of the substrate cleaned in the cleaning step; and
a thin film formation step for forming a thin film on the surface of the substrate plasma-treated in the pre-treatment step, wherein
the thin film formation step comprises performing a series of steps for a plurality of times, the series of steps includes:
a sputtering step for sputtering a target made of at least one kind of metal in a thin film formation process area formed in a vacuum chamber so as to adhere a film material made of the metal onto the surface of the substrate;
a substrate conveying step for conveying the substrate into a reaction process area formed at a position distant from the thin film formation process area in the vacuum chamber; and
a reaction step for generating plasma of a reactive gas in a state where the reactive gas is introduced into the reaction process area and reacting the reactive gas and the film material, so as to generate a compound or an imperfect compound of the reactive gas and the film material, and
the pre-treatment step is performed in the reaction process area where plasma of an oxygen gas is generated.

3. The manufacturing method of the optical filter according to claim 2, wherein
only the oxygen gas is introduced to the reaction process area in the pre-treatment step, and
a flow rate of the oxygen gas introduced to the reaction process area in the pre-treatment step is greater than a flow rate of the oxygen gas introduced to the reaction process area in the thin film formation step.

4. A manufacturing method of an optical filter, comprising:
a cleaning step for cleaning a substrate;
a pre-treatment step for plasma-treating a surface of the substrate cleaned in the cleaning step; and
a thin film formation step for forming a thin film on the surface of the substrate plasma-treated in the pre-treatment step, wherein
the thin film formation step comprises performing a series of steps for a plurality of times, the series of steps includes:
a sputtering step for sputtering a target made of at least one kind of metal in a thin film formation process area formed in a vacuum chamber so as to adhere a film material made of the metal onto the surface of the substrate;
a substrate conveying step for conveying the substrate into a reaction process area formed at a position distant from the thin film formation process area in the vacuum chamber; and
a reaction step for generating plasma of a reactive gas in a state where the reactive gas is introduced into the reaction process area and reacting the reactive gas and the film material, so as to generate a compound or an imperfect compound of the reactive gas and the film material, and
the pre-treatment step is performed by generating plasma of an oxygen gas in an oxygen plasma treatment area partitioned from both the thin film formation process area and the reaction process area while maintaining airtightness.
